Europäisches Patentamt

European Patent Office

Office européen des brevets

(11) Veröffentlichungsnummer: **0 381 849**
**A1**

(12) **EUROPÄISCHE PATENTANMELDUNG**

(21) Anmeldenummer: 89123631.7

(51) Int. Cl.5: **H01L 23/498**

(22) Anmeldetag: 21.12.89

(30) Priorität: 07.02.89 CH 408/89

(43) Veröffentlichungstag der Anmeldung:
16.08.90 Patentblatt 90/33

(84) Benannte Vertragsstaaten:
CH DE FR GB IT LI SE

(71) Anmelder: ASEA BROWN BOVERI AG
Haselstrasse
CH-5401 Baden(CH)

(72) Erfinder: Kloucek, Franz, Dr.
Brückenstrasse 10
CH-5430 Wettingen(CH)

(54) Schnelle Leistungshalbleiterschaltung.

(57) Bei einer schnellen Leistungshalbleiter-Schaltung mit einem über ein Gate abschaltbaren Bauelement in Form eines grossflächigen Halbleitersubstrats (9) und einer Ansteuerschaltung, die an Gate und Kathode des Bauelements angeschlossen ist, und einen zum Abschalten des Bauelements geeigneten Stromimpuls erzeugt, wird eine niederinduktive Verbindung zwischen Bauelement und Ansteuerschaltung durch einen Bandleiter (28) in Form einer metall-kaschierten Kunststoff-Folie realisiert.

Die obere Metallisierung (1) des Bandleiters (28) dient dabei im wesentlichen als Zuleitung zur Kathode des Bauelements, die untere Metallisierung (3) als Zuleitung zum Gate.

FIG.4

EP 0 381 849 A1

## SCHNELLE LEISTUNGSHALBLEITER-SCHALTUNG

### TECHNISCHES GEBIET

Die vorliegende Erfindung bezieht sich auf das Gebiet der Leistungselektronik. Sie betrifft insbesondere eine schnelle Leistungshalbleiter-Schaltung, umfassend

(a) ein über ein Gate abschaltbares Bauelement mit einer Anode und einer Kathode, welches Bauelement in der Form eines grossflächigen Halbleitersubstrats mit einer Anodenseite und einer der Anodenseite gegenüberliegenden Kathodenseite vorliegt, wobei die Anode auf der Anodenseite, und die Kathode zusammen mit dem Gate auf der Kathodenseite angeordnet ist; und

(b) eine Ansteuerschaltung, welche an das Gate und die Kathode angeschlossen ist, und einen Stromimpuls zum Abschalten des Bauelements erzeugt.

Eine solche Schaltung ist z.B. aus der EP-A2-0 228 226 bekannt.

### STAND DER TECHNIK

Die neuen, schnellen, über ein Gate abschaltbaren Leistungshalbleiter-Bauelemente, die in der Leistungselektronik zunehmend Verwendung finden, wie z.B. der FCTh (Field Controlled Thyristor), der IGBT (Insulated Gate Bipolar Transistor) oder der HF-GTO erfordern zur Ansteuerung kurze Stromimpulse mit sehr hohen Stromanstiegsgeschwindigkeiten di/dt.

Um solche hohen di/dt-Werte erreichen zu können, sind für die Induktivität L des Ansteuerkreises Gesamtwerte von nur einigen nH oder unter Umständen von < 1 nH erlaubt. Eine Anordnung des Ansteuerkreises ausserhalb des Bauelement-Gehäuses und eine Zuleitung der Steuerpulse z.B. durch Koaxialkabel ist damit nicht mehr möglich.

Eine mögliche Lösung für das Induktivitätsproblem bestände darin, die entsprechenden Ansteuerkreise auf der Gateseite direkt über dem Halbleitersubstrat anzubringen ("Huckepack"-Anordnung). Diese Lösung hätte jedoch folgende Nachteile:
- zu hoher Platzbedarf;
- für Bauelemente mit einem Durchmesser > 1" sind Druckkontakte nicht realisierbar; und
- die Kühlung der Ansteuerkreise bei hohen Frequenzen z.B. in einem Modul bereitet Probleme.

### DARSTELLUNG DER ERFINDUNG

Aufgabe der vorliegenden Erfindung ist es daher, eine Leistungshableiter-Schaltung mit einem abschaltbaren Bauelement zu schaffen, bei der die Ansteuerung niederinduktiv ist, und die Ansteuerschaltung in einer günstigen Entfernung zum Bauelement angebracht werden kann.

Die Aufgabe wird bei einer Schaltung der eingangs genannten Art dadurch gelöst, dass

(c) die Ansteuerschaltung mit dem Halbleitersubstrat durch einen grossflächigen Bandleiter verbunden ist;

(d) der Bandleiter eine in der Mitte liegende Isolierschicht umfasst, welche auf der einen Seite mit einer oberen Metallisierung und auf der anderen Seite mit einer unteren Metallisierung versehen ist; und

(e) die obere Metallisierung im wesentlichen als Zuleitung zur Kathode und die untere Metallisierung im wesentlichen als Zuleitung zum Gate verwendet wird.

Der Kern der Erfindung besteht darin, das Halbleitersubstrat des Bauelements mit der Ansteuerschaltung durch einen extrem niederinduktiven Bandleiter zu verbinden, der gleichzeitig zur Montage der einzelnen Elemente (Kondensatoren und MOSFETs) der Ansteuerschaltung verwendet werden kann.

Gemäss einer ersten bevorzugten Ausführungsform der Erfindung besteht die Isolierschicht des Bandleiters aus einer flexiblen Polyimid-Kunststoff-Folie und die obere und untere Metallisierung jeweils aus Cu.

Eine weitere Ausführungsform der Erfindung zeichnet sich dadurch aus, dass

(a) auf der Kathodenseite des Halbleitersubstrats für den Anschluss von Kathode und Gate über die Fläche verteilt Kathodenkontakte und Gatekontakte vorgesehen sind;

(b) auf der unteren Seite des Bandleiters die untere Metallisierung aufgeteilt ist in eine Gatemetallisierung mit Gatebereichen sowie separate Kathodenbereiche, wobei die Kathodenbereiche den Kathodenkontakten und die Gatebereiche den Gatekontakten entsprechen;

(c) der Bandleiter mit seiner unteren Seite das Halbleitersubstrat auf der Kathodenseite grossflächig kontaktiert, wobei die Kathodenbereiche auf den Kathodenkontakten und die Gatebereiche auf den Gatekontakten aufliegen; und

(d) die Kathodenbereiche mit der oberen Metallisierung des Bandleiters mittels Durchkontaktierungen leitend verbunden sind.

Weitere Ausführungsformen ergeben sich aus den Unteransprüchen.

## KURZE BESCHREIBUNG DER ZEICHNUNG

Die Erfindung soll nachfolgend anhand von Ausführungsbeispielen im Zusammenhang mit der Zeichnung näher erläutert werden. Es zeigen:

Fig.1 den Schnitt durch einen Bandleiter, wie er bei der Erfindung verwendet wird;

Fig.2 das Schaltbild einer bevorzugten Ausführungsform der erfindungsgemässen Schaltung;

Fig.3 die Draufsicht auf die Kathodenseite eines FCTh, wie er in einem Ausführungsbeispiel der Erfindung eingesetzt wird;

Fig.4a die Draufsicht auf die untere Seite eines Bandleiters für einen FCTh gemäss Fig.3, sowie einen entsprechenden Querschnitt;

Fig.4b die Draufsicht auf die obere Seite eines Bandleiters gemäss Fig.4a mit den montierten Kondensatoren und MOSFETs der Ansteuerschaltung;

Fig.4c den Schnitt durch eine fertig verdrahtete Schaltung mit einem FCTh gemäss Fig.3 und einem Bandleiter gemäss Fig.4a,b;

Fig.5 den Schnitt durch eine zu Fig.4c analoge Anordnung mit zusätzlicher, antiparalleller Diode;

Fig.6 den Schnitt durch eine Anordnung mit rotationssymmetrischem Halbleitersubstrat und Bandleiter in einem zylindrischen Isoliergehäuse; und

Fig.7 die Draufsicht auf einen Bandleiter, wie er in einer Anordnung gemäss Fig.6 verwendet wird.

## WEGE ZUR AUSFÜHRUNG DER ERFINDUNG

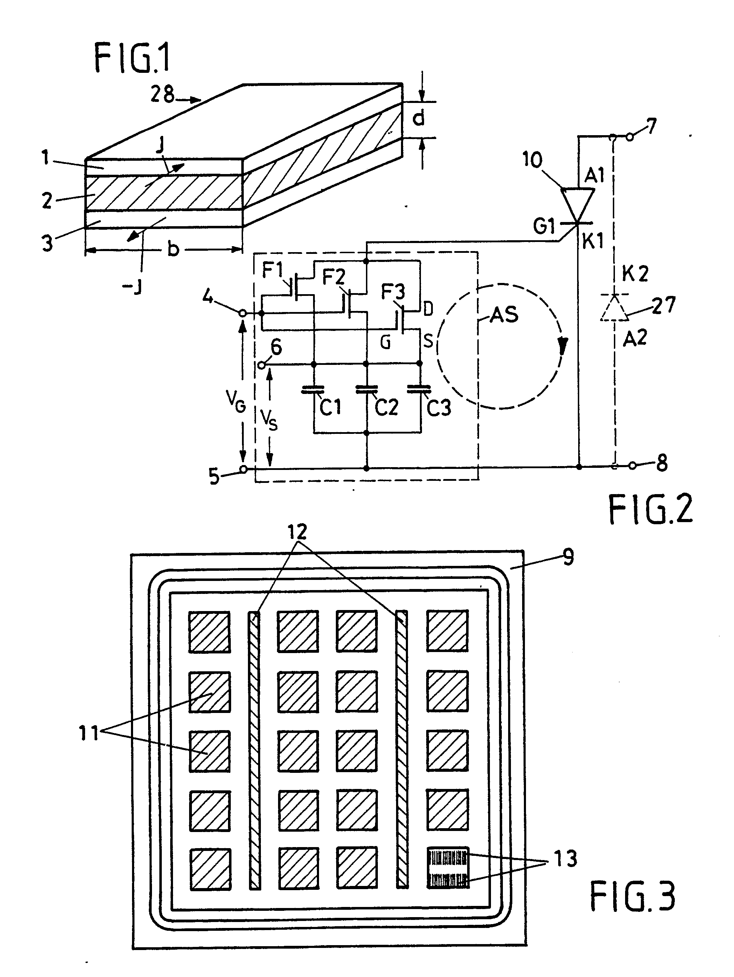

Kernstück der vorgeschlagenen niederinduktiven Anordnung aus Halbleiterbauelement und damit verbundener Ansteuerschaltung ist ein Bandleiter 28, wie er schematisch in Fig.1 im Querschnitt dargestellt ist.

Der Bandleiter 28 setzt sich zusammen aus einer in der Mitte liegenden Isolierschicht 2, die auf der oberen Seite mit einer oberen Metallisierung 1 und auf der unteren Seite mit einer entsprechenden unteren Metallisierung 3 versehen ist.

Als Isolierschicht 2 wird bevorzugt eine flexible Kunststoff-Folie eingesetzt, die (wegen der Spannungsfestigkeit und Temperaturbeständigkeit beim Löten) insbesondere aus einem Polyimid bestehen kann. Für die Metallisierungen 1 und 3 wird vorzugsweise Cu verwendet. Eine solche kupferkaschierte Folie ist beispielsweise als Basismaterial für flexible Leiterplatinen bekannt.

Die beiden Metallisierungen 1 und 3 des Bandleiters 28 dienen als Zu- und Ableitungen für den Steuerstrom (J bzw. -J) im Ansteuerkreis des Halbleiterbauelements. Eine derartige Bandleiteranord

nung hat (nach M. Hess, Elektro nik, Heft 18, 1988) bei einer Breite b des Bandleiters 28 und einer Dicke d der Isolierschicht 2 näherungsweise einen Induktionsbelag $L'$ (Induktivität pro Leiterlänge) von $L' = 1257(d/b)$ [nH/m].

$L'$ kann beliebig verkleinert werden, indem die Breite b vergrössert oder die Dicke d der Isolierschicht 2 (bzw. der Kunststoff-Folie) verkleinert wird. Das Minimum der Dicke d ist dabei durch die jeweils geforderte elektrische Durchschlagsfestigkeit gegeben.

Mit technisch realisierbaren Abmessungen von $d = 1.10^{-4}$ m und $b = 0,02$ m erhält man $L' = 6,3$ nH/m. Zum Vergleich hat eine typische Koaxialleitung mit einem Wellenwiderstand von 50 Ω einen Induktionsbelag von $L' = 241$ nH/m. Man erkennt hieraus sofort, dass es bei den geforderten geringen Induktivitäten von wenigen nH im Ansteuerkreis nur die Bandleiteranordnung prinzipiell möglich macht, die Ansteuerschaltung in relativ grosser Distanz von bis zu 1 m Entfernung vom Leistungshalbleiter anzuordnen.

Als Beispiel für eine Leistungshalbleiter-Schaltung nach der Erfindung soll nachfolgend die schaltungstechnische Realisierung für die Ansteuerung eines FCThS in einem Modulgehäuse näher beschrieben werden. Die hier dargestellten Ansteuerprinzipien gelten jedoch genauso für andere schnelle, abschaltbare Bauelemente wie z.B. die IGBTs und HF-GTOs.

Der Basiskreis für eine solche Ansteuerschaltung AS ist in der Fig.2 wiedergegeben. Die Ansteuerschaltung AS liegt zwischen dem Gate G1 und der Kathode K1 eines Bauelements 10 und enthält in diesem Ausführungsbeispiel drei parallel geschaltete Ansteuerkreise mit jeweils einem MOSFET F1,..,F3 und einem niederinduktiven keramischen Kondensator C1,..,C3. Der Stromfluss, der die niederinduktive Ansteuerung einschliesst, ist in der Figur durch einen kreisförmigen Pfeil gekennzeichnet.

Die Kondensatoren C1,..,C3 werden über die Eingangsklemmen 5 und 6 mittels einer Versorgungsspannung $V_S$ aufgeladen. Die Steuerung der MOSFETs F1,..,F3 durch eine Steuerspannung VG erfolgt über die Eingangsklemmen 4 und 5. Das Bauelement 10 ist mit der Anode A1 und der Kathode K1 an die Ausgangsklemmen 7 und 8 angeschlossen, die mit der zu schaltenden Last verbunden werden.

Optional kann zu dem Bauelement 10 eine Diode 27 (mit der Anode A2 und der Kathode K2) antiparallel geschaltet sein, auf die weiter unten noch näher eingegangen wird.

Die in der Fig.2 gezeigte Parallelschaltung mehrerer Ansteuerkreise ist im übrigen nur dann erforderlich, wenn die Ansteuerschaltung AS grosse Stromimpulse liefern muss, welche die Lei

stungsfähigkeit eines einzelnen MOSFETs übersteigen. Andererseits können weitere Ansteuerkreise parallel geschaltet werden, um eine gleichmässigere Stromverteilung zu erreichen.

Das in Fig.2 eingezeichnete Bauelement 10 kann - wie bereits erwähnt - von unterschiedlichem Aufbau und unterschiedlicher Wirkungsweise sein, soll hier jedoch als FCTh ausgebildet sein. Fig.3 zeigt in der Draufsicht das kathodenseitige Metallisierungsmuster eines solchen beispielhaften FCTh höherer Leistung (220 A), wie er durch den Ansteuerkreis grossflächig kontaktiert werden muss.

Der unkontaktierte FCTh der Figur besteht aus einem rechteckigen Halbleitersubstrat 9, in das durch eine Vielzahl von Herstellungsschritten eine Folge von unterschiedlich dotierten Schichten eingebracht worden ist, die für einen FCTh charakteristisch und bekannt sind (siehe dazu z.B. die EP-A2 0 178 387).

Die Kathodenseite des FCTh weist eine stufenförmige Gate-Kathoden-Struktur mit einer Vielzahl von länglichen Kathodenfingern 13 auf, die aus einer tieferliegenden Gateebene herausragen.

In dem Beispiel der Fig.3 sind jeweils zwei Reihen von (z.B. 50) Kathodenfingern 13 zu einem Teilthyristor zusammengefasst und mit einem gemeinsamen Kathodenkontakt 11 versehen (bei einem der 20 Teilthyristoren in Fig.3 ist der Kathodenkontakt 11 weggelassen, um die Lage der Kathodenfinger 13 zeigen zu können). Zwischen den rechteckigen Teilthyristoren mit ihren Kathodenkontakten 11 sind längliche Gatekontakte 12 angeordnet, die mit der tieferliegenden Gateebene in Verbindung stehen.

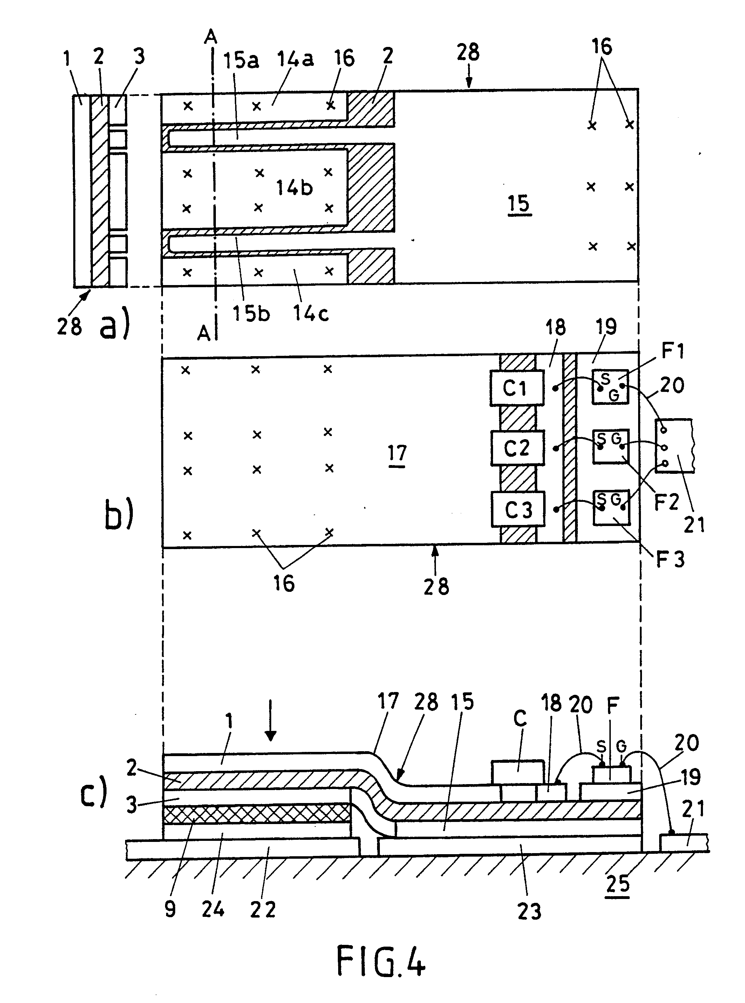

Der FCTh aus Fig.3 und seine Ansteuerschaltung AS gemäss Fig.2 werden nun verbunden und bilden eine Modul, wie es in Fig.4c dargestellt ist.

Grundlage des Moduls ist ein isolierendes Keramiksubstrat 25 mit in geeigneter Weise strukturierten Substratmetallisierungen 21,..,23. Die erste Substratmetallisierung 21 entspricht in ihrer Funktion der Eingangsklemme 4 in Fig.2 und dient als Basis für die Verbindungen zu den Gates der MOSFETs F1,..,F3.

Das Halbleitersubstrat 9 des FCTh ist anodenseitig mit einer dazwischenliegenden Molybdänplatte 24 auf die zweite Substratmetallisierung 22 gebondet. Von der obenliegenden Kathodenseite des Halbleitersubstrats 9 führt ein Bandleiter 28 zu der nebenliegenden dritten Substratmetallisierung 23.

Die durch Aetzen strukturierte untere Metallisierung 3 des Bandleiters 28 ist gemäss Fig.4a aufgeteilt in eine grossflächige Gatemetallisierung 15 mit daran anschliessenden Gatebereichen 15a,b. Die Gatebereiche 15a,b ihrerseits sind umgeben von Kathodenbereichen 14a,b,c.

Wenn der Bandleiter 28 mit seiner unteren Metallisierung 3 auf dem gegenüber Fig.3 um 90° gedrehten Halbleitersubstrat 9 zu liegen kommt, kontaktieren die Gatebereiche 15a,b die entsprechenden Gatekontakte 12, und die Kathodenbereiche 14a,b,c die entsprechenden Kathodenkontakte 11.

Die Verbindung zwischen den Bereichen 14a,b,c bzw. 15a,b und den Kontakten 11 bzw. 12 erfolgt bevorzugt über eine Lötverbindung (ggf. mit einer in Fig.4c nicht eingezeichneten Molybdänplatte als Zwischenlage) im linken Bereich des Bandleiters 28, ist aber auch durch eine reine Druckbelastung (angedeutet durch den Pfeil) möglich.

Die durch Aetzen strukturierte obere Metallisierung 1 des Bandleiters 28 ist gemäss Fig.4b aufgeteilt in eine grossflächige Kathodenmetallisierung 17, eine Sourcemetallisierung 18 und eine Drainmetallisierung 19. Die Kathodenmetallisierung 17 steht mit den Kathodenbereichen 14a,b,c auf der anderen Seite der Isolierschicht 2 über Durchkontaktierungen 16 in leitender Verbindung. In der gleichen Weise sind die Gatemetallisierung 15 und die Drainmetallisierung 19 miteinander verbunden.

Die beschriebenen Durchkontaktierungen 16 zwischen der oberen Metallisierung 1 und der unteren Metallisierung 3 des Bandleiters 28 bewirken, dass die erstere im wesentlichen als Zuleitung zur Kathode K1 und die letztere im wesentlichen als Zuleitung zum Gate G1 des FCTh verwendet wird.

Zwischen der Kathodenmetallisierung 17 und der Sourcemetallisierung 18 sind die Kondensatoren C1,..,C3 durch Leitkleber oder Löten auf dem Bandleiter 28 aufgebracht. Entsprechend sind auf der Drainmetallisierung 19 die MOSFETS F1,..,F3 mit der Drainseite nach unten angeordnet.

Source S und Gate G der MOSFETs F1,..,F3 sind mit der Sourcemetallisierung 18 bzw. der ersten Substratmetallisierung 21 jeweils durch Bonddrähte 20 verbunden (Fig.4b,c). Diese Kontaktierungsart ist bezüglich der Induktivität der Ansteuerkreises ausgesprochen kritisch. Die Verdrahtung sollte daher so flach wie möglich parallel zum Bandleiter 28 geführt werden.

Im übrigen können anstelle der MOSFETs F1,..,F3 auch bipolare Leistungstransistoren oder andere schnelle Bauelemente verwendet werden, die den Einsatz günstigerer planarer Kontaktierungsmethoden mit Blechstreifen erlauben und so weniger Zusatzinduktivität in die Ansteuerkreise einführen.

Durch die Verwendung des Bandleiters 28 ist es weiterhin problemlos möglich, innerhalb eines Moduls gemäss Fig.4c zusätzlich eine ultraschnelle Freilaufdiode mitzukontaktieren, die für die meisten Brückenschaltungen in Umrichtern benötigt wird. Wie bereits im Zusammenhang mit der Fig.2 erwähnt, ist eine solche Diode 27 antiparallel zum FCTh geschaltet.

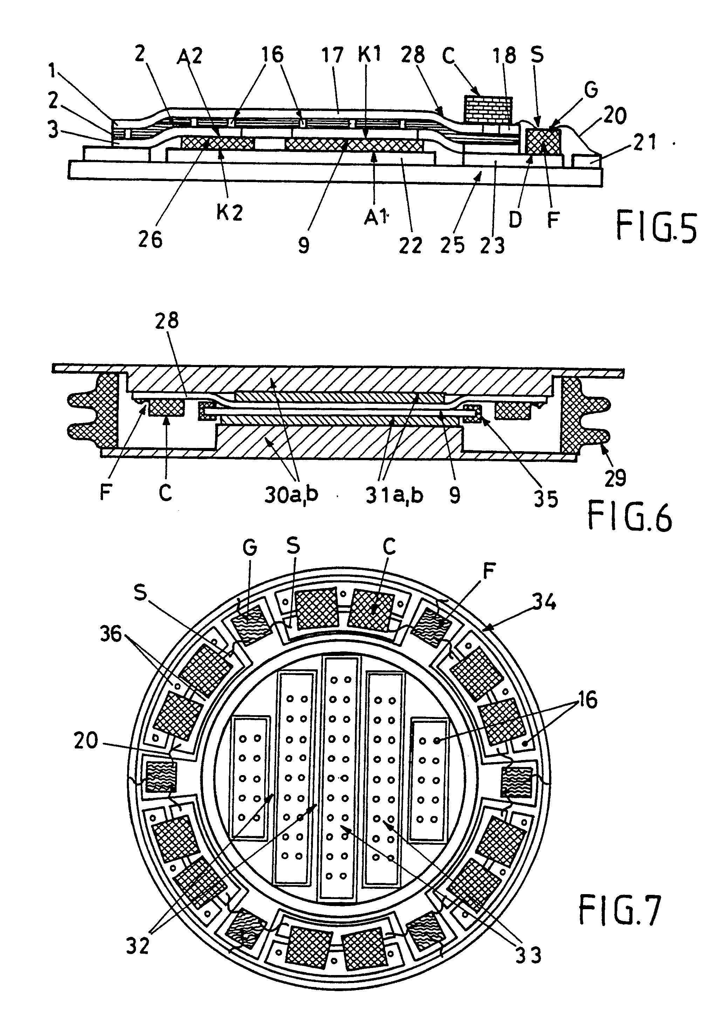

Die Integration der Diode 27 in Form eines Diodenchips 26 führt zu einem Modulaufbau, wie er Fig.5 dargestellt ist. Der Diodenchip 26 ist direkt neben dem Halbleitersubstrat 9 des FCTh auf der zweiten Substratmetallisierung 22 angeordnet. Seine Kathode K2 und seine Anode A2 sind gegenüber der Anode A1 und der Kathode K1 des FCTh vertauscht. Die Anode A2 wird grossflächig von der unteren Seite des Bandleiters 28 kontaktiert.

Die MOSFETs F sind in dieser Ausführungsform nicht auf der Oberseite des Bandleiters 28 sondern direkt auf der dritten Substratmetallisierung 23 des Substrats 25 plaziert. Hierdurch werden die kritischen Leitungswege zusätzlich verkürzt.

Bei Bauelementen mit Durchmessern von 1,5 Zoll und mehr sind Lötkontakte wenig geeignet für die elektrische Kontaktierung und die Abfuhr der Verlustwärme aus dem Bauelement. Es wird dann ein sogenannter Druckkontakt verwendet, bei dem die Kontaktierung durch das Anpressen von Kontaktscheiben mit einem ausreichenden Anpressdruck sichergestellt wird.

Das Verdrahtungsprinzip mit dem Bandleiter ist prinzipiell auch geeignet, eine extrem niederinduktive Ansteuerung für den Druckkontakt eines grossen FCTh oder andere grossflächige und schnelle Bauelemente zu gewährleisten.

Ein bevorzugtes Ausführungsbeispiel für eine solche niederinduktive Druckkontakt-Anordnung ist in den Fig.6 und 7 wiedergegeben. In einem zylindrischen Isoliergehäuse 29 ist das (in diesem Fall runde) Halbleitersubstrat 9 (mit einer geeigneten Randpassivierung 35) zwischen zwei Molybdänscheiben 31a,b und zwei weiter aussen liegenden Kupferscheiben 30a,b eingespannt.

Der Bandleiter 28 ist zwischen der oberen der beiden Molybdänscheiben 31a,b und dem Halbleitersubstrat 28 angeordnet und drückt mit seiner in Fig.7 in Draufsicht dargestellten und durch Aetzen strukturierten unteren Seite auf die Kathoden- und Gatekontakte des Bauelements. Die Kondensatoren C und MOSFETs F sind auf derselben unteren Seite des Bandleiters 28 an der Peripherie, d.h. auf dem über das Halbleitersubstrat 9 hinausragenden Rand, symmetrisch um den FCTh verteilt montiert.

Im dargestellten Beispiel sind sechs Ansteuerkreise mit jeweils zwei Kondensatoren C und einem MOSFET F parallel geschaltet (Fig.7). Die untere Metallisierung des Bandleiters 28 ist dazu (wie Fig.7 zeigt) in Kathodenbereiche 33, Gatebereiche 32, Ringbereiche 36 und eine Ringleitung 34 aufgeteilt. Die Kondensatoren C sind zwischen den Ringbereichen 36 angeordnet, von denen jeweils die äusseren mittels Durchkontaktierungen 16 mit der anderen Seite des Bandleiters 28 verbunden sind.

Die rechteckigen Kathodenbereiche 33 sind ebenfalls mittels Durchkontaktierungen 16 direkt zur oberen Seite des Bandleiters 28 und damit zur oberen der beiden Kupferscheiben 30a,b durchkontaktiert.

Die an der äusseren Kante des Bandleiters 28 entlanglaufende Ringleitung 34 ist mit den Gates G der MOSFETs F verbunden, während deren Sources S jeweils an die inneren der Ringbereiche 36 angeschlossen sind und die Gates G direkt mit den Gatebereichen 32 in Verbindung stehen.

Der Stromfluss für den Ansteuerimpuls erfolgt damit vom Gate G1 des FCTh über Drain D und Source S der MOSFETs F, dann über die Kondensatoren C und die Durchkontaktierungen 16 in den Ringbereichen 36 auf die obere Seite des Bandleiters 28 und von dort über die Durchkontaktierungen 16 innerhalb der Kathodenbereiche 33 zurück zur Kathode K1 des FCTh.

Die kathodenseitige Metallisierung des FCTh muss wie der innere Bereich des in Fig.7 dargestellten Bandleiters 28 aussehen, d.h. die Kathode ist in rechteckige Segmente und das Gate ist in entsprechende Streifen aufgeteilt.

Insgesamt können also mit der Erfindung schnelle Leistungshalbleiterschaltungen mit abschaltbaren Bauelementen realisiert werden, die aufgrund der niederinduktiven Verbindung zwischen Bauelement und Ansteuerung die Verwirklichung hoher Schaltfrequenzen gestatten.

## Ansprüche

1. Schnelle Leistungshalbleiter-Schaltung, umfassend

(a) ein über ein Gate (G1) abschaltbares Bauelement (10) mit einer Anode (A1) und einer Kathode (K1), welches Bauelement in der Form eines grossflächigen Halbleitersubstrats (9) mit einer Anodenseite und einer der Anodenseite gegenüberliegenden Kathodenseite vorliegt, wobei die Anode (A1) auf der Anodenseite, und die Kathode (K1) zusammen mit dem Gate (G1) auf der Kathodenseite angeordnet ist; und

(b) eine Ansteuerschaltung (AS), welche an das Gate (G1) und die Kathode (K1) angeschlossen ist, und einen Stromimpuls zum Abschalten des Bauelements erzeugt;
dadurch gekennzeichnet, dass

(c) die Ansteuerschaltung (AS) mit dem Halbleitersubstrat (9) durch einen grossflächigen Bandleiter (28) verbunden ist;

(d) der Bandleiter (28) eine in der Mitte liegende Isolierschicht (2) umfasst, welche auf der einen Seite mit einer oberen Metallisierung (1) und auf der anderen Seite mit einer unteren Metallisierung (3) versehen ist; und

(e) die obere Metallisierung (1) im wesentlichen als Zuleitung zur Kathode (K1) und die untere Metallisierung (3) im wesentlichen als Zuleitung zum Gate (G1) verwendet wird.

2. Schaltung nach Anspruch 1, dadurch gekennzeichnet, dass die Isolierschicht (2) des Bandleiters (28) aus einer flexiblen Kunststoff-Folie besteht.

3. Schaltung nach Anspruch 2, dadurch gekennzeichnet, dass

(a) die Kunststoff-Folie aus einem Polyimid hergestellt ist; und

(b) die obere und untere Metallisierung (1 bzw.3) aus Cu bestehen.

4. Schaltung nach Anspruch 1, dadurch gekennzeichnet, dass

(a) die Ansteuerschaltung (AS) eine Mehrzahl von Kondensatoren (C,C1,..,C3) und MOSFETs (F,F1,..,F3) umfasst, wobei jeweils ein Kondensator und ein MOSFET in Serie geschaltet und die Kondensatoren (C,C1,..,C3) und MOSFETs (F,F1,..,F3) untereinander jeweils parallelgeschaltet sind; und

(b) zumindest die Kondensatoren (C,C1,..,C3) auf dem Bandleiter (28) selbst angeordnet und befestigt sind.

5. Schaltung nach Anspruch 4, dadurch gekennzeichnet, dass auch die MOSFETs (F,F1,..,F3) auf dem Bandleiter (28) angeordnet und befestigt sind.

6. Schaltung nach Anspruch 1, dadurch gekennzeichnet, dass

(a) auf der Kathodenseite des Halbleitersubstrats (9) für den Anschluss von Kathode (K1) und Gate (G1) über die Fläche verteilt Kathodenkontakte (11) und Gatekontakte (12) vorgesehen sind;

(b) auf der unteren Seite des Bandleiters (28) die untere Metallisierung (3) aufgeteilt ist in eine Gate metallisierung (15) mit Gatebereichen (15a,b;32) sowie separate Kathodenbereiche (14a,b,c;33), wobei die Kathodenbereiche (14a,b,c;33) den Kathodenkontakten (11) und die Gatebereiche (15a,b;32) den Gatekontakten (12) entsprechen;

(c) der Bandleiter (28) mit seiner unteren Seite das Halbleitersubstrat (9) auf der Kathodenseite grossflächig kontaktiert, wobei die Kathodenbereiche (14a,b,c;33) auf den Kathodenkontakten (11) und die Gatebereiche (15a,b;32) auf den Gatekontakten (12) aufliegen; und

(d) die Kathodenbereiche (14a,b,c;33) mit der oberen Metallisierung (1) des Bandleiters (28) mittels Durchkontaktierungen (16) leitend verbunden sind.

7. Schaltung nach Anspruch 6, dadurch gekennzeichnet, dass

(a) das Halbleitersubstrat (9) mit der Anodenseite auf einem Keramiksubstrat (25) befestigt ist;

(b) der Bandleiter (28) ausserhalb des Halbleitersubstrats (9) mit seiner Gatemetallisierung (15) ebenfalls auf dem Keramiksubstrat (25) befestigt ist;

(c) die Ansteuerschaltung (AS) eine Mehrzahl von Kondensatoren (C,C1,..,C3) und MOSFETs (F,F1,..,F3) umfasst, wobei jeweils ein Kondensator und ein MOSFET in Serie geschaltet und die Kondensatoren (C,C1,..,C3) und MOSFETs (F,F1,..,F3) untereinander jeweils parallelgeschaltet sind;

(d) auf der oberen Seite des Bandleiters (28) die obere Metallisierung (1) aufgeteilt ist in eine den Kathodenbereichen (14a,b,c) gegenüberliegende Kathodenmetallisierung (17) und eine separate, der Gatemetallisierung (15) gegenüberliegende Sourcemetallisierung (18); und

(e) die Kondensatoren (C,C1,..,C3) auf der oberen Seite des Bandleiters (28) zwischen der Kathodenmetallisierung (17) und der Sourcemetallisierung (18) angeordnet sind.

8. Schaltung nach Anspruch 7, dadurch gekennzeichnet, dass

(a) die obere Metallisierung (1) des Bandleiters (28) neben der Kathodenmetallisierung (17) und der Sourcemetallisierung (18) noch eine weitere separate Drainmetallisierung (19) umfasst; und

(b) die MOSFETs (F,F1,..,F3) auf der oberen Seite des Bandleiters (28) im Bereich der Drainmetallisierung (18) angeordnet sind.

9. Schaltung nach Anspruch 7, dadurch gekennzeichnet, dass

(a) dem Bauelement eine Diode (27) in Form eines Diodenchips (26) antiparallel geschaltet ist;

(b) der Diodenchip (26) neben dem Halbleitersubstrat (9) mit der Kathodenseite auf dem Keramiksubstrat (25) befestigt ist; und

(c) der Bandleiter (28) mit seiner unteren Seite den Diodenchip (26) auf der Anodenseite grossflächig kontaktiert.

10. Schaltung nach Anspruch 6, dadurch gekennzeichnet, dass

(a) das Halbleitersubstrat (9) und der Bandleiter (28) Kreisform haben, wobei der Durchmesser des Bandleiters (28) grösser ist als der Durchmesser des Halbleitersubstrats (9);

(b) der Bandleiter (28) und das Halbleitersubstrat (9) konzentrisch übereinanderliegend in einem zylindrischen Isoliergehäuse (29) zwischen zwei innenliegenden Molybdänscheiben (31a,b) und zwei aussenliegenden Kupferscheiben (30a,b) eingespannt sind;

(c) die Ansteuerschaltung (AS) eine Mehrzahl von Kondensatoren (C,C1,..,C3) und MOSFETs (F,F1,..,F3) umfasst, wobei jeweils ein Kondensator und ein MOSFET in Serie geschaltet und die Kondensatoren (C,C1,..,C3) und MOSFETs (F,F1,..,F3) untereinander jeweils parallelgeschaltet sind; und

(d) die Kondensatoren (C,C1,..,C3) und MOSFETs (F,F1,..,F3) auf dem über das Halbleitersubstrat (9) überstehenden Rand des Bandleiters (28) um das Halbleitersubstrat (9) herum angeordnet sind.

EP 0 381 849 A1

FIG.1

FIG.2

FIG.3

89/016

FIG.4

FIG.5

FIG.6

FIG.7

| | Europäisches Patentamt | **EUROPÄISCHER RECHERCHENBERICHT** | Nummer der Anmeldung |
|---|---|---|---|

EP   89 12 3631

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-268260 (INTERNATIONAL BUSINESS MACHINES) * Spalte 4, Zeile 35 - Spalte 5, Zeile 5; Ansprüche 1, 6; Figur 3 * --- | 1-4 | H01L23/498 |
| A | US-A-3519895 (J. MARINO) * Spalte 2, Zeilen 20 - 46 * * Spalte 2, Zeile 59 - Spalte 3, Zeile 41; Figuren 2, 3 * --- | 1-3, 6 | |
| A | US-A-3358196 (J.J. STEINMETZ) * Spalte 2, Zeilen 4 - 16 * * Spalte 2, Zeile 37 - Spalte 3, Zeile 6 * * Spalte 3, Zeile 71 - Spalte 4, Zeile 6 * * Spalte 4, Zeilen 25 - 51; Figuren 1-4 * ----- | 1, 6 | |

**RECHERCHIERTE SACHGEBIETE (Int. Cl.5)**

H01L

Der vorliegende Recherchenbericht wurde für alle Patentansprüche erstellt

| Recherchenort | Abschlußdatum der Recherche | Prüfer |
|---|---|---|
| DEN HAAG | 11 MAI 1990 | DELPORTE B.P.M. |